(19) Europäisches Patentamt
European Patent Office
Office européen des brevets

(11) **EP 3 696 557 B1**

(12) **EUROPÄISCHE PATENTSCHRIFT**

(45) Veröffentlichungstag und Bekanntmachung des Hinweises auf die Patenterteilung:
**07.12.2022 Patentblatt 2022/49**

(21) Anmeldenummer: **20150831.4**

(22) Anmeldetag: **09.01.2020**

(51) Internationale Patentklassifikation (IPC):
**G01R 27/02** (2006.01)

(52) Gemeinsame Patentklassifikation (CPC):
**G01R 27/025**

(54) **VERFAHREN UND GERÄTE ZUR BESTIMMUNG DER ELEMENTE EINES DIELEKTRISCHEN ERSATZSCHALTBILDES FÜR EINE ISOLIERUNG EINES ELEKTRISCHEN SYSTEMS**

METHOD AND EQUIPMENT FOR DETERMINING THE ELEMENTS OF A DIELECTRIC REPLACEMENT CIRCUIT FOR INSULATING AN ELECTRICAL SYSTEM

PROCÉDÉ ET APPAREILS DE DÉTERMINATION DES ÉLÉMENTS D'UN SCHÉMA ÉQUIVALENT DIÉLECTRIQUE POUR UN ISOLEMENT D'UN SYSTÈME ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.02.2019 DE 102019103396**

(43) Veröffentlichungstag der Anmeldung:
**19.08.2020 Patentblatt 2020/34**

(73) Patentinhaber: **Bender GmbH & Co. KG**
**35305 Grünberg (DE)**

(72) Erfinder:
• **REITZ, Julian**
**35305 Grünberg (DE)**
• **BRÖCKMANN, Eckhard**
**35396 Gießen (DE)**

(74) Vertreter: **advotec.**
**Patent- und Rechtsanwaltspartnerschaft Tappe mbB**
**Georg-Schlosser-Straße 6**
**35390 Gießen (DE)**

(56) Entgegenhaltungen:
DE-A1-102014 016 245

• **RAINER PATSCH ET AL: "Return Voltage Measurements - a good tool for the diagnosis of paper-oil insulations", POWER TECH, 2005 IEEE RUSSIA, IEEE, PISCATAWAY, NJ, USA, 27. Juni 2005 (2005-06-27), Seiten 1-7, XP031254941, ISBN: 978-5-93208-034-4**
• **MULLER F ET AL: "Deriving an Equivalent Circuit of Transformers Insulation for Understanding the Dielectric Response Measurements", IEEE TRANSACTIONS ON POWER DELIVERY, IEEE SERVICE CENTER, NEW YORK, NY, US, Bd. 20, Nr. 1, 1. Januar 2005 (2005-01-01), Seiten 149-157, XP011124438, ISSN: 0885-8977, DOI: 10.1109/TPWRD.2004.835436**

**Beschreibung**

Die Erfindung betrifft ein Verfahren und Geräte zur Bestimmung der Elemente eines dielektrischen Ersatzschaltbildes für eine Isolierung eines elektrischen Systems, wobei das Ersatzschaltbild eine Parallelschaltung ist aus einem Fehlerwiderstand, einer Ableitkapazität und einem Absorptionsglied, welches aus einer Reihenschaltung eines Absorptionswiderstands und einer Absorptionskapazität gebildet ist.

Stromversorgungssysteme weisen elektrisch leitfähige Elemente auf, die unter bestimmten Bedingungen durch ein Isolationsmaterial voneinander getrennt werden müssen. Insbesondere ist bei der Installation ungeerdeter Stromversorgungssysteme eine Überwachung eines Isolationswiderstandes erforderlich. Der komplexwertige Isolationswiderstand (Isolationsimpedanz) wird dabei durch ein Ersatzschaltbild der stromversorgenden elektrischen Leitung modelliert, welches aus einer Parallelschaltung einer Ableitkapazität und einem ohmschen Fehlerwiderstand (Realteil der Isolationsimpedanz) besteht. Zur Überwachung des Fehlerwiderstands werden bevorzugt Isolationsüberwachungsgeräte (IMDs) eingesetzt. Besonders anspruchsvoll gestaltet sich die Messung des Isolationswiderstands bei elektrischen Anlagen mit einem sehr hohen Isolationsniveau größer als 500 M$\Omega$. Hierzu zählen z.B. Seekabel oder Hochvolt-Batterien (HV-Batterien).

Aktuelle Isolationsüberwachungsgeräte, welche zwar für den hochohmigen Messbereich optimiert wurden, jedoch auf bestehender Analysetechnik basieren, weisen Unzulänglichkeiten hinsichtlich der Messgenauigkeit auf. Als Fehlerquelle wird hierbei ein für diese hochohmigen Anwendungen unzureichendes Ersatzschaltbild ausgemacht, welches die dielektrische Absorption des Isolierungsmaterials nicht berücksichtigt.

Aus dem IEEE Standard 43-2000 entnimmt man ein Ersatzschaltbild für Isolierungen, welches neben der genannten Parallelschaltung der Ableitkapazität und des Fehlerwiderstandes um ein zusätzlich parallel geschaltetes RC-Reihenglied, ein aus einem Absorptionswiderstand $R_a$ und einer Absorptionskapazität $C_a$ bestehendes Absorptionsglied, ergänzt wird, welches das dielektrische Absorptionsverhalten quantifiziert.

Die dielektrischen Eigenschaften einer Isolierung verändern sich durch Alterung und Umgebungseigenschaften mit der Zeit und können als Indikator für die frühzeitige Erkennung einer schleichenden Verschlechterung der Isolierung angesehen werden. Eine regelmäßige Quantifizierung des Dielektrikums könnte somit ergänzend zur bisher bekannten ausschließlichen Messung des ohmschen Fehlerwiderstands genutzt werden, um Alterungserscheinungen von Isolierungen deutlich früher zu erkennen und deren elektrischen Zustand bewerten zu können. Dadurch könnten Wartungsmaßnahmen an dem elektrischen System noch früher geplant werden.

Zur direkten Quantifizierung des Ersatzschaltbildes mit dielektrischer Betrachtung einer Isolierung in einem elektrischen System insbesondere in einem aktiven ungeerdeten Stromversorgungssystem, ist derzeit keine technische Lösung bekannt.

In ungeerdeten Stromversorgungssystemen werden die dielektrischen Eigenschaften des Isolationsmaterials gegenwärtig außer Acht gelassen, lediglich die Auswirkung einer Verschlechterung der Isolierung durch kontinuierliche Messung des Fehlerwiderstandes wird verfolgt. In geerdeten Netzen wird vor allem die zyklische Messung eines Polarisationsindexes vorgenommen, wobei das Netz allerdings in nachteiliger Weise abgeschaltet werden muss. Der Polarisationsindex ist eine künstliche Größe und gibt Aufschluss über die dielektrischen Eigenschaften einer Isolierung, ohne diese jedoch zu quantifizieren.

Weiterhin ist das Verfahren der Impedanzspektroskopie bekannt, welches sich jedoch vor allem auf labormäßige Untersuchungen im Bereich der Materialwissenschaften beschränkt und im Frequenzbereich arbeitet. Zudem ist dieses Verfahren für einen enorm hochohmigen Bereich und für einen Einsatz am aktiven elektrischen System ungeeignet. Weiterer Stand der Technik findet sich in RAINER PATSCH ET AL: "Return Voltage Measurements - a good tool for the diagnosis of paper-oil insulations",POWER TECH, 2005 IEEE RUSSIA, IEEE, PISCATAWAY, NJ, USA, 27. Juni 2005 (2005-06-27), Seiten 1-7, XP031254941,ISBN: 978-5-93208-034-4.

Der vorliegenden Erfindung liegt somit die Aufgabe zugrunde, ein Verfahren und eine Anordnung zur Bestimmung der Elemente eines dielektrischen Ersatzschaltbildes für eine Isolierung eines elektrischen Systems vorzuschlagen, wobei als elektrisches System insbesondere ein ungeerdetes Stromversorgungssystem während des Betriebs betrachtet werden soll.

Diese Aufgabe wird mit den Merkmalen des Anspruchs 1 gelöst.

Nach Anlegen eines Spannungssprungs als Prüfspannung $u_0$(t) einer Spannungsquelle mit einem in Reihe zu der Spannungsquelle liegenden bekannten Messwiderstand $R_m$ an das elektrische System erfolgt eine Messung und eine Aufzeichnung der Sprungantwort $u_a$(t) über eine Messperiode $T_m$, deren Dauer näherungsweise der zweifachen Dauer der Einschwingphase der Sprungantwort $u_a$(t) entspricht. Im Gegensatz zu aus dem Stand der Technik bekannten Verfahren, bei denen die Messung im Hinblick auf eine schnelle Ermittlung des Isolationswiderstands abgebrochen wird sobald ein stationärer Zustand erreicht wird, erfolgt die Messung und Aufzeichnung hier über einen längere Messperiode $T_m$.

Es werden also sämtliche Datenpunkte der Sprungantwort $u_a$(t) über die Dauer der Messperiode $T_m$ gespeichert und nachfolgend einer digitalen Signalverarbeitung unterzogen. Dabei wird zunächst aus dem Verlauf der vollständig

eingeschwungenen Sprungantwort $u_a(t)$ zwischen der Hälfte der Messperiode $T_m$ und dem Ende der Messperiode $T_m$ auf analytischem Wege bevorzugt über eine Mittelwertbildung der Fehlerwiderstand $R_f$ ermittelt.

Die Zeitkonstante $\tau$ wird aus dem Verlauf der Sprungantwort $u_a(t)$ in der Einschwingphase bestimmt, wobei das Ende der Einschwingphase in etwa der fünffachen Zeitkonstanten $\tau$ entspricht. Aus der Zeitkonstanten $\tau$, dem Fehlerwiderstand $R_f$ und dem Messwiderstand $R_m$ wird ein Startwert $C_{e0}$ der Ableitkapazität $C_e$ berechnet.

Nach dieser analytischen Bestimmung des Fehlerwiderstands $R_f$ und des Startwertes $C_{e0}$ der Ableitkapazität $C_e$ erfolgt eine Bestimmung der Elemente des Absorptionsgliedes $R_a$ und $C_a$ sowie der Ableitkapazität $C_e$ mittels numerischer Signalverarbeitung.

Dazu wird ein Näherungsalgorithmus verwendet, welcher unter Zuhilfenahme des bekannten Messwiderstands $R_m$ und der bereits analytisch ermittelten Ersatzschaltbildelemente Fehlerwiderstand $R_f$ und Startwert $C_{e0}$ der Ableitkapazität $C_e$ das tatsächliche Messsignal, also die aufgezeichnete Sprungantwort $u_a(t)$, fortlaufend nachsimuliert. Startwerte für den Absorptionswiderstand $R_a$ und die Absorptionskapazität $C_a$ bilden aus Wertefeldern entnommene Näherungswerte $R'_a$, $C'_a$ und $C'_e$.

Zur Simulation der Sprungantwort $u_a(t)$ wird eine Übertragungsfunktion G(s) des durch das Ersatzschaltbild mit den Ersatzschaltbildelementen $R_f$, $C_e$, $R_a$, $C_a$ und dem Messwiderstand $R_m$ modellierten elektrischen Systems analytisch gebildet, die das Verhältnis zwischen einem Ausgangsignal $U'_a(s)$ über dem Messwiderstand $R_m$ und einem Prüfsignal $U_0(s)$ der Spannungsquelle als Eingangssignal wiedergibt:

$$G(s)) = U'_a(s))/U_0(s)$$

$$G(s)) = \frac{(R_m \cdot R_f \cdot R_a \cdot C_e \cdot C_a)s^2 + (R_m(R_a \cdot C_a + C_e \cdot R_f + R_f \cdot C_a))s + R_m}{(R_m \cdot R_f \cdot R_a \cdot C_e \cdot C_a)s^2 + R_m(R_a \cdot C_a + C_e \cdot R_f + R_f \cdot C_a) + R_f \cdot R_a \cdot C_a) \; \pm \; R_m + R_f)}$$

Die Abhängigkeit von der Variablen s bezeichnet die (in Großbuchstaben geschriebene) Laplace-Transformierte der entsprechenden (in Kleinbuchstaben) geschriebenen Zeitbereichsgröße. Mit Strich versehene Größen stellen iterativ veränderliche Größen im Sinne der Näherungslösung dar.

Mithilfe dieser Übertragungsfunktion G(s) wird das Ausgangssignal $U'_a(s) = U_0(s)*G(s)$ berechnet, welches sich bei der Anregung des durch die Übertragungsfunktion G(s) beschriebenen elektrischen Systems mit der Sprungfunktion als Prüfsignal $U_0(s)$ ergibt. Die Berechnung erfolgt unter Einbeziehung des berechneten Fehlerwiderstands $R_f$, des berechneten Startwertes $C_{e0}$ der Ableitkapazität $C_e$ und des bekannten Messwiderstands $R_m$, wobei der Absorptionswiderstand $R_a$, die Absorptionskapazität $C_a$ und die Ableitkapazität $C_e$ jeweils durch Näherungswerte $R'_a$, $C'_a$, $C'_e$ mittels des Näherungs-Algorithmus iterativ so bestimmt werden, dass die Abweichung zwischen dem berechneten, in den Zeitbereich transformierten ($u'_a(t)$) Ausgangsignal $U'_a(s)$ und der gemessenen, aufgezeichneten Sprungantwort $u_a(t)$ minimiert wird.

Unterschreitet die Abweichung einen gewissen Schwellwert, kann der Näherungsprozess abgebrochen werden und die Elemente $R_a$, $C_a$, $C_e$ des Ersatzschaltbildes können durch die Näherungswerte $R'_a$, $C'_a$, $C'_e$ als hinreichend genau bestimmt angesehen werden.

Mit Vorteil minimiert der Näherungs-Algorithmus die Abweichung in einem Zeitabschnitt zwischen der vier- bis fünffachen Zeitkonstante $\tau$ und dem messtechnischen Ende der Einschwingphase bei etwa 3/5 der Messperiode $T_m$.

Der Näherungsalgorithmus konzentriert sich auf den Signalabschnitt zwischen dem Zeitpunkt, bei welchem in etwa die vier bis fünffache Zeitkonstante $\tau$ erreicht ist und dem messtechnischen Ende des Einschwingvorgangs, wobei hier durchaus eine Bereichsüberlappung vorliegen kann.

Um eine schnellere Annäherung an die durch die Datenpunkte aufgezeichnete Sprungantwort zu erreichen, beschränkt sich der Näherungsalgorithmus auf die Minimierung der Abweichung auf den mittleren Bereich des Signalverlaufs und blendet den Start und Endbereich der Sprungantwort $u_a(t)$ aus. In Abhängigkeit von den Anwendungserfordernissen kann dieser mittlere Bereich verkürzt oder erweitert werden, um beispielsweise durch eine Verkürzung den Annäherungsabschnitt "schärfer zu stellen".

In weiterer Ausgestaltung arbeitet der Näherungsalgorithmus nach der Methode der kleinsten Quadrate.

Als Näherungsverfahren wird die aus dem Stand der Technik bekannte Methode der kleinsten Quadrate verwendet (MKQ/LS - Least Squares). Dazu werden die Größen Absorptionswiderstand $R_a$, Absorptionskapazität $C_a$ und Ableitkapazität $C_e$ der Übertragungsfunktion G(s) numerisch derart bestimmt, dass die Summe der quadratischen Abweichung der mit den Näherungswerten dieser Parameter berechneten Sprungantwort, also das in den Zeitbereich transformierte ($u'_a(t)$) Ausgangsignal $U'_a(t)$ von den aufgezeichneten Datenpunkten der Sprungantwort $u_a(t)$ minimiert wird.

Bevorzugt findet eine Anwendung numerisch des Verfahrens zur Bestimmung der dielektrischen Eigenschaften einer Isolierung in ungeerdeten Stromversorgungssystemen in Verbindung mit einer Isolationsüberwachung statt.

Da eine Überwachung des Isolationswiderstands in ungeerdeten Stromversorgungsnetzen normativ vorgeschrieben ist und wobei Isolationsüberwachungsgeräte nach der Produktnorm IEC61 557-8 zur Verwendung vorgeschrieben sind, ist das erfindungsgemäße Verfahren besonders vorteilhaft einsetzbar zur Verbesserung der Messgenauigkeit bei der Bestimmung des Isolationswiderstands in ungeerdeten Stromversorgungsnetzen.

Zwar ist das erfindungsgemäße Verfahren vorrangig für die Anwendung in ungeerdeten Stromversorgungsnetzen konzipiert, ist jedoch nicht auf dieses Anwendungsgebiet beschränkt. Das Verfahren kann damit über die Anwendung in ungeerdeten Stromversorgungssystemen hinausgehen und allgemein in elektrischen Systemen angewendet werden, jedoch muss gegebenenfalls ein vorhandener Schutzleiter, beispielsweise in einem geerdeten Netz, abgeklemmt werden. Besonders wirksam ist das Verfahren einsetzbar in elektrischen Systemen deren Isolationswiderstand größer als 100 MΩ ist, da bei kleineren Impedanzen die Polarisationsströme vernachlässigbar klein sind.

In Umsetzung des erfindungsgemäßen Verfahrens wird die der Erfindung zugrundeliegende Aufgabe weiterhin durch ein Prüfgerät zur Bestimmung der Elemente eines dielektrischen Ersatzschaltbildes für eine Isolierung eines elektrischen Systems gelöst, welches eine Signalverarbeitungseinrichtung aufweist, die zur Ausführung des erfindungsgemäßen Verfahrens nach den Ansprüchen 1 bis 4 ausgelegt ist. Insoweit treffen die mit dem erfindungsgemäßen Verfahren bewirkten Vorteile auch in analoger Weise auf ein erfindungsgemäßes Prüfgerät zu, welches zur Durchführung des erfindungsgemäßen Verfahrens ausgelegt ist.

Neben der Realisierung des erfindungsgemäßen Verfahrens in einem eigenständigen Prüfgerät kann das Verfahren mit Vorteil auch in ein Isolationsüberwachungsgerät zur Ermittlung eines Isolationswiderstands eines ungeerdeten Stromversorgungssystems implementiert werden, wobei dieses Isolationsüberwachungsgerät eine Signalverarbeitungsrichtung aufweist, die zur Ausführung des erfindungsgemäßen Verfahrens nach den Ansprüchen 1 bis 4 ausgelegt ist.

Zur Verbesserung der Messgenauigkeit bei der Bestimmung des Isolationswiderstands, insbesondere bei ungeerdeten Stromversorgungssystemen mit einem sehr hohen Isolationsniveau größer als 500 MΩ, kann ein vorhandenes normativ vorgeschriebenes Isolationsüberwachungsgerät durch eine Signalverarbeitungseinrichtung erweitert werden, die das erfindungsgemäße Verfahren ausführt.

Bevorzugt weist das Isolationsüberwachungsgerät einen variablen Messwiderstand $R_m$ und/oder eine variabel Ankoppelimpedanz zur rauscharmen Erfassung bei einer Prüfspannung $u_0(t)$ mit variabler Amplitude auf.

Ein variabler Messwiderstand und/oder eine variable Ankoppelimpedanz des Isolationsüberwachungsgeräts ermöglicht eine besonders rauscharme Erfassung insbesondere bei Prüfspannungen mit variabler Amplitude.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern. Es zeigen

**Fig. 1** Ein dielektrisches Ersatzschaltbild für eine Isolierung,

**Fig. 2** einen Verlauf der Spannung über dem Messwiderstand $R_m$ (Sprungantwort $u_a(t)$)

**Fig. 3** Schritte der numerischen Signalverarbeitung mit Näherungsalgorithmus,

**Fig. 4** ein erfindungsgemäßes Prüfgerät in einem ungeerdeten Stromversorgungssystem und

**Fig. 5** ein Isolationsüberwachungsgerät mit erfindungsgemäßer Signalverarbeitungseinrichtung.

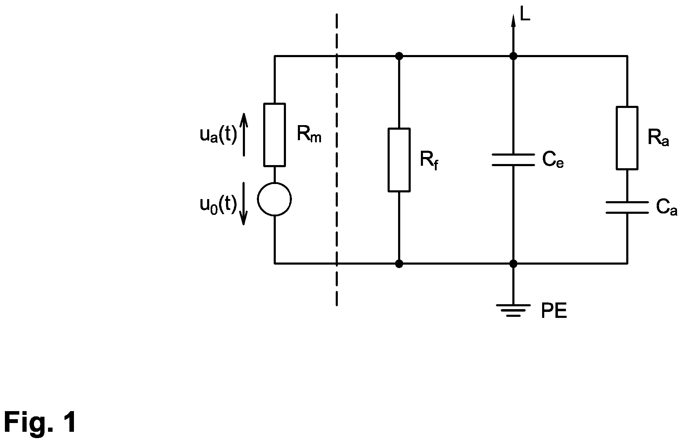

In **Fig. 1** ist ein dielektrisches Ersatzschaltbild für eine Isolierung in einem Prüfstromkreis dargestellt. Zwischen einem Leiter L, beispielsweise eines ungeerdeten Stromversorgungssystems, und Erde PE sind der Fehlerwiderstand $R_f$ und die Ableitkapazität $C_e$ wirksam, die zusammen den komplexwertigen Isolationswiderstand (Isolationsimpedanz) des ungeerdeten Stromversorgungssystems bilden. Um das dielektrische Absorptionsverhalten der Isolierung zwischen dem Leiter L und Erde PE zu beschreiben, wird das Ersatzschaltbild durch ein zu der Isolationsimpedanz parallel geschaltetes Absorptionsglied, bestehend aus der Reihenschaltung eines Absorptionswiderstandes $R_a$ und einer Absorptionskapazität $C_a$, erweitert.

Zur Bestimmung der Ersatzschaltbildgrößen $R_f$, $C_e$, $R_a$ und $C_a$ ist das dielektrische Ersatzschaltbild in einen Prüfstromkreis eingebunden, welcher eine Prüfspannung $u_0(t)$ und einen Messwiderstand $R_m$ aufweist, über den im Falle der Beaufschlagung mit einer Sprungfunktion als Prüfspannung $u_0(t)$ eine Sprungantwort $u_a(t)$ gemessen werden kann.

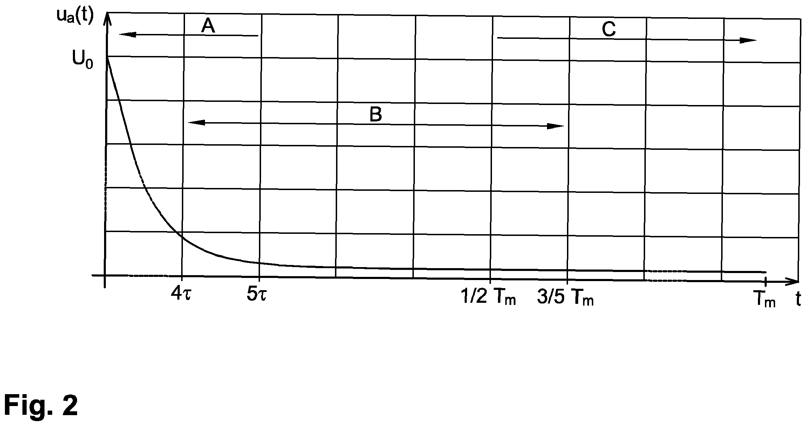

In **Fig. 2** ist der Verlauf der Spannung über dem Messwiderstand $R_m$ dargestellt. Der Spannungsverlauf entspricht der Sprungantwort $u_a(t)$ bei Anlegen einer Sprungfunktion als Prüfspannung $u_0(t)$. Die Sprungantwort $u_a(t)$ wird über eine Messperiode $T_m$ aufgezeichnet, wobei diese Messperiode $T_m$ in drei Teilabschnitte A, B und C aufgeteilt werden kann, die sich auch überlappen können.

Der Zeitabschnitt A erstreckt sich von einem Zeitpunkt t=0, an dem die Spannungsamplitude den Wert der Höhe der Sprungfunktion $U_0$ aufweist, bis in etwa zu dem Zeitpunkt $5^*\tau$, wobei $\tau$ die Zeitkonstante des exponentiellen Spannungsverlaufs bildet. Ein zweiter Zeitabschnitt B erstreckt sich in etwa von dem vier- bis fünffachen der Zeitkonstanten bis ca. zu 3/5 der Messperiode $T_m$. Ein dritter Zeitabschnitt C umfasst die Zeitdauer von in etwa der Hälfte der Messperiode $T_m$ bis zum Ende der Messperiode $T_m$. Aus diesem Zeitabschnitt C, der den eingeschwungenen Zustand repräsentiert, und in dem die Ableitkapazität $C_e$ und die Absorptionskapazität $C_a$ näherungsweise als Leerlauf betrachtet werden können, wird bei bekanntem Messwiderstand $R_m$ der Fehlerwiderstand $R_f$ vorzugsweise über eine Mittelwertbildung berechnet. Ausgehend von der Annahme, dass der Einschwingvorgang näherungsweise bei dem fünffachen der Zeitkonstanten $\tau$ beendet ist, wird aus der so ermittelten Zeitkonstanten $\tau$ und mit Kenntnis des Messwiderstandes $R_m$ sowie des zuvor bestimmten Fehlerwiderstands $R_f$ ein Startwert $C_{e0}$ für die Ableitkapazität $C_e$ bestimmt.

Nach dieser analytischen Berechnung des Fehlerwiderstandes $R_f$ aus dem Zeitabschnitt C, und der analytischen Bestimmung des Startwertes $C_{e0}$ der Ableitkapazität $C_e$ aus dem Zeitabschnitt A erfolgt in dem mittleren Zeitabschnitt B der Sprungfunktion $U_a(t)$ eine numerische Bestimmung des Absorptionswiderstands $R_a$, der Absorptionskapazität $C_a$ sowie die genauere Bestimmung der Ableitkapazität $C_e$ durch einen Näherungsalgorithmus.

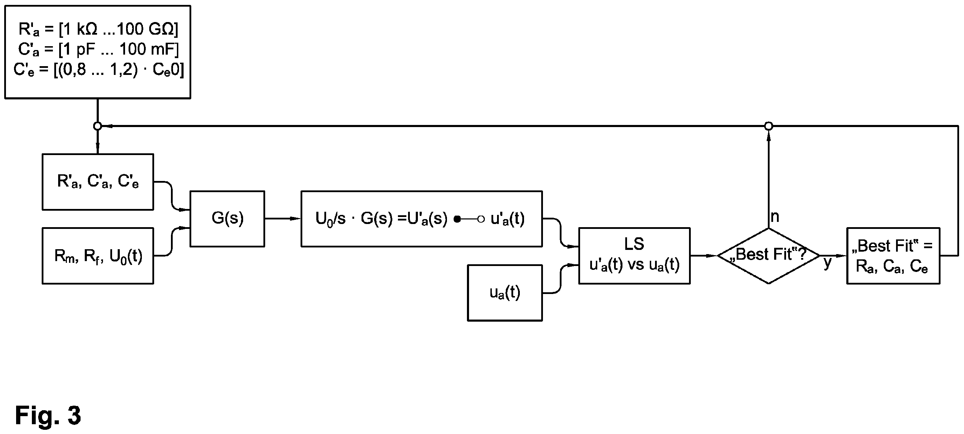

In **Fig. 3** sind die Schritte der digitalen Signalverarbeitung dargestellt, um auf numerischem Wege über das Näherungsverfahren Näherungswerte $R'_a$, $C'_a$, $C'_e$ für den Absorptionswiderstand $R_a$, die Absorptionskapazität $C_a$ sowie die Ableitkapazität $C_e$ iterativ zu ermitteln.

Ausgehend von breiten Wertefeldern für den Absorptionswiderstand $R_a$ (1 kΩ ... 100 GΩ), für die Absorptionskapazität $C_a$ (1 pF... 100 mF) und die Ableitkapazität $C_e=(0,8 ... 1,2)^*C_{e0}$ werden damit zunächst Startwerte für diese drei Größen festgelegt. Sinnvollerweise kann auch auf anlagenspezifische Erfahrungswerte zurückgegriffen werden.

Unter weiterer Einbeziehung des bekannten Wertes für den Messwiderstand $R_m$ und des ermittelten Fehlerwiderstands $R_f$ wird die Übertragungsfunktion G(s) berechnet. Die Übertragungsfunktion wird mit der Laplace-transformierten Sprungfunktion $U_0(s)$ (Sprunghöhe $U_0$) multipliziert und ergibt das Ausgangssignal $U'_a(s)$. Dieses Ausgangssignal $U'_a(s)$ führt zu dem in den Zeitbereich transformierten Ausgangsignal $u'_a(t)$, das nach der Methode der kleinsten Quadrate mit der real erfassten Sprungantwort $u_a(t)$ verglichen wird. Durch fortlaufende Variation der Näherungswerte $R'_a$, $C'_a$, $C'_e$ für den Absorptionswiderstand $R_a$, für die Absorptionskapazität $C_a$ und die Ableitkapazität $C_e$ wird iterativ die Berechnung einer neuen Übertragungsfunktion G(s) solange durchgeführt, bis bei einem Vergleich des in den Zeitbereich transformierten Ausgangsignals $u'_a(t)$ mit der aufgezeichneten Sprungantwort $u_a(t)$ die Summe der Fehlerquadrate einen gesetzten Schwellwert unterschreitet. Damit sind die Werte des Absorptionswiderstands $R_a$, der Absorptionskapazität $C_a$ und der Ableitkapazität $C_e$ hinreichend genau bestimmt.

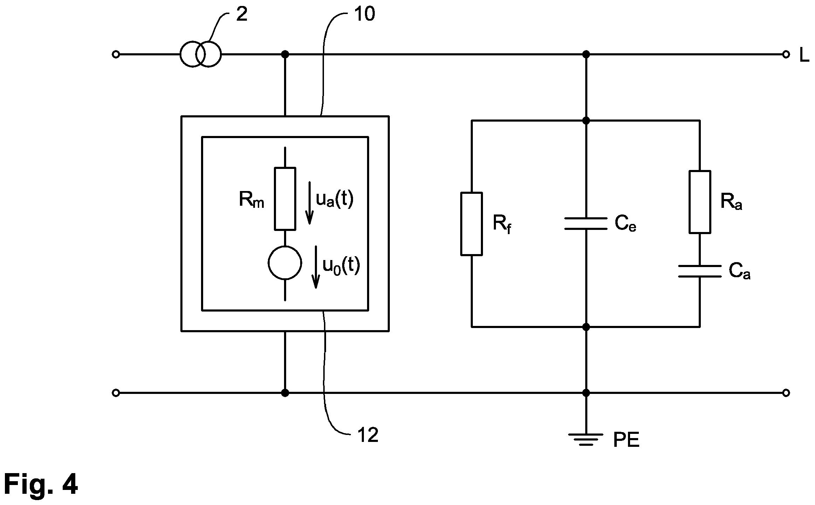

Die **Fig. 4** zeigt ein erfindungsgemäßes Prüfgerät 10 in einem ungeerdeten Stromversorgungssystem 2. Das Prüfgerät 10 wird zwischen den aktiven Leiter L des Stromversorgungssystems 2 und Erde PE geschaltet und umfasst eine erfindungsgemäße Signalverarbeitungseinrichtung 12 die zur Ausführung des erfindungsgemäßen Verfahrens ausgelegt ist.

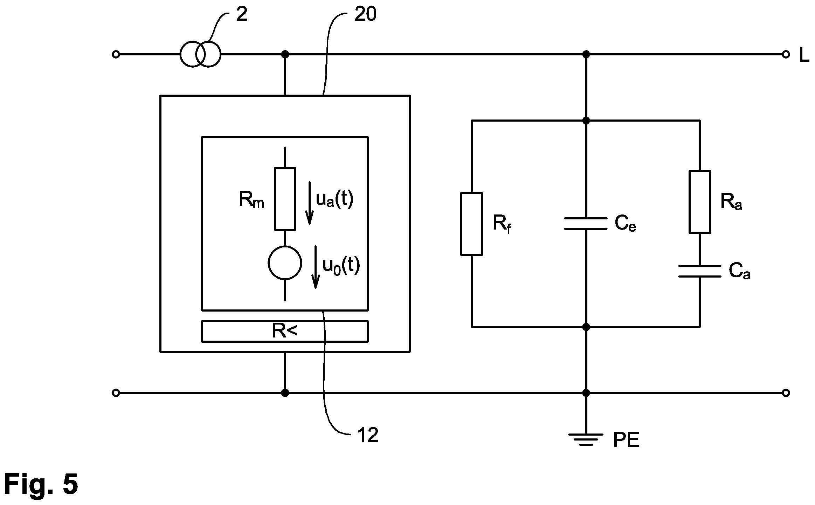

In **Fig. 5** ist ein Isolationsüberwachungsgerät 20 in dem ungeerdeten Stromversorgungssystem 2 gezeigt. Das normgemäße Isolationsüberwachungsgerät 20 ist zwischen den aktiven Leiter L des Stromversorgungssystem 2 und Erde PE geschaltet und weist zusätzlich die erfindungsgemäße Signalverarbeitungseinrichtung 12 zur Ausführung des erfindungsgemäßen Verfahrens zur Bestimmung der Elemente des dielektrischen Ersatzschaltbildes für eine Isolierung auf.

**Patentansprüche**

1. Verfahren zur Bestimmung der Elemente eines dielektrischen Ersatzschaltbildes für eine Isolierung eines elektrischen Systems, wobei das Ersatzschaltbild eine Parallelschaltung ist aus einem Fehlerwiderstand ($R_f$), einer Ableitkapazität ($C_e$) und einem Absorptionsglied, welches aus einer Reihenschaltung eines Absorptionswiderstands ($R_a$) und einer Absorptionskapazität ($C_a$) gebildet ist, umfassend die Verfahrensschritte:

   Anlegen eines Spannungssprungs als Prüfspannung ($u_0(t)$) einer Spannungsquelle mit einem in Reihe zu der Spannungsquelle liegenden bekannten Messwiderstand ($R_m$) an das elektrische System;
   Messen einer an dem Messwiderstand ($R_m$) abfallenden Spannung als Sprungantwort ($u_a(t)$) des elektrischen Systems;
   **gekennzeichnet durch**
   Aufzeichnen der Sprungantwort ($u_a(t)$) über eine Messperiode ($T_m$), deren Dauer näherungsweise einer zweifachen Einschwingphase der Sprungantwort ($u_a(t)$) entspricht;
   Berechnen des Fehlerwiderstands ($R_f$) aus dem Verlauf der Sprungantwort ($u_a(t)$) im eingeschwungenen Zustand;
   Bestimmen der Zeitkonstanten ($\tau$) aus dem Verlauf der Sprungantwort ($u_a(t)$) in der Einschwingphase;

Berechnen eines Startwertes ($C_{e0}$) der Ableitkapazität ($C_e$) aus der Zeitkonstanten ($\tau$), dem Fehlerwiderstand ($R_f$) und dem Messwiderstand ($R_m$);

Bilden einer Übertragungsfunktion ($G(s)$) des durch das Ersatzschaltbild mit den Ersatzschaltbildelementen ($R_f$, $C_e$, $R_a$, $C_a$) und dem Messwiderstand ($R_m$) modellierten elektrischen Systems als Verhältnis zwischen einem Ausgangsignal ($U'_a(s)$) über dem Messwiderstand ($R_m$) und einem Prüfsignal ($U_0(s)$) der Spannungsquelle als Eingangssignal;

Berechnen des Ausgangssignals ($U'_a(s)$) aus der Übertragungsfunktion ($G(s)$) mit einer Sprungfunktion als Prüfsignal ($U_0(s)$) unter Einbeziehung des berechneten Fehlerwiderstands ($R_f$), des berechneten Startwertes ($C_{e0}$) der Ableitkapazität ($C_e$) und des bekannten Messwiderstands ($R_m$), wobei

der Absorptionswiderstand ($R_a$), die Absorptionskapazität ($C_a$) und die Ableitkapazität ($C_e$) jeweils durch Näherungswerte ($R'_a$, $C'_a$, $C'_e$) mittels eines Näherungs-Algorithmus iterativ so bestimmt werden, dass die Abweichung zwischen dem berechneten, in den Zeitbereich transformierten Ausgangsignal ($u'_a(t)$) und der gemessenen, aufgezeichneten Sprungantwort ($u_a(t)$) minimiert wird.

2. Verfahren nach Anspruch 1,
**dadurch gekennzeichnet,**
**dass** der Näherungs-Algorithmus die Abweichung in einem Zeitabschnitt zwischen der vier- bis fünffachen Zeitkonstanten ($\tau$) und dem messtechnischen Ende der Einschwingphase bei etwa 3/5 der Messperiode ($T_m$) minimiert.

3. Verfahren nach Anspruch 1 oder 2,
**dadurch gekennzeichnet,**
**dass** der Näherungs-Algorithmus nach der Methode der kleinsten Quadrate arbeitet.

4. Verfahren nach einem der Ansprüche 1 bis 3,
**gekennzeichnet durch,**
eine Anwendung zur Bestimmung der dielektrischen Eigenschaften einer Isolierung in ungeerdeten Stromversorgungssystemen in Verbindung mit einer Isolationsüberwachung.

5. Prüfgerät zur Bestimmung der Elemente eines dielektrischen Ersatzschaltbildes für eine Isolierung eines elektrischen Systems,
**gekennzeichnet durch**
eine Signalverarbeitungseinrichtung, die zur Ausführung des erfindungsgemäßen Verfahrens zur Bestimmung der Elemente eines dielektrischen Ersatzschaltbildes für eine Isolierung eines elektrischen Systems nach den Ansprüchen 1 bis 4 ausgelegt ist.

6. Isolationsüberwachungsgerät zur Ermittlung eines Isolationswiderstands eines ungeerdeten Stromversorgungssystems,
**gekennzeichnet durch**
eine Signalverarbeitungseinrichtung, die zur Ausführung des erfindungsgemäßen Verfahrens zur Bestimmung der Elemente eines dielektrischen Ersatzschaltbildes für eine Isolierung eines ungeerdeten Stromversorgungssystems nach den Ansprüchen 1 bis 4 ausgelegt ist.

7. Isolationsüberwachungsgerät nach Anspruch 6,
**gekennzeichnet durch**
einen variablen Messwiderstand ($R_m$) und/oder eine variable Ankoppelimpedanz zur rauscharmen Erfassung bei einer Prüfspannung ($u_0(t)$) mit variabler Amplitude.

**Claims**

1. A method for determining the elements of a dielectric equivalent circuit diagram for an insulation of an electric system, the equivalent circuit diagram being a parallel connection made up of a fault resistance (Rf), a leakage capacitance (Ce) and an absorption element which is made up of a series connection of an absorption resistance ($R_a$) and an absorption capacitance ($C_a$), the method comprising the steps:

applying a voltage step to the electric system as a test voltage (uo (t)) of a voltage source having a known measurement resistance ($R_m$) in series to the voltage source;
measuring a voltage dropping at the measurement resistance ($R_m$) as a step response (ua(t)) of the electric system;

**characterized by**

recording the step response (ua(t)) over a measuring period ($T_m$) whose duration approximately corresponds to a two-fold settling phase of the step response (ua(t));

calculating the fault resistance (Rf) from the progression of the step response (ua(t)) in the settled state;

determining the time constants ($\tau$) from the progression of the step response (ua(t)) in the settling phase;

calculating an initial value ($C_{e0}$) of the leakage capacitance (Ce) from the time constants ($\tau$), the fault resistance ($R_f$) and the measurement resistance ($R_m$);

forming a transfer function (G(s)) of the electric system, which was modelled by the equivalent circuit diagram using the equivalent circuit diagram elements (Rf, $C_e$, $R_a$, $C_a$) and the measurement resistance ($R_m$), as a ratio between an output signal (U'a(s)) at the measurement resistance ($R_m$) and a test signal (Uo(s)) of the voltage source as an input signal;

calculating the output signal (U'a(s)) from the transfer function (G(s)) using a step function as a test signal (Uo(s)) while incorporating the calculated fault resistance (Rf), the calculated initial value ($C_{e0}$) of the leakage capacitance (Ce) and the known measurement resistance ($R_m$),

the absorption resistance ($R_a$), the absorption capacitance ($C_a$) and the leakage capacitance (Ce) each being iteratively determined in such a manner via approximate values ($R'_a$, $C'_a$, $C'_e$) by means of an approximation algorithm that the deviation between the calculated output signal (u'$_a$(t)) transformed in the time range and the measured recorded step function (ua(t)) is minimized.

2. The method according to claim 1,
   **characterized in that**
   the approximation algorithm minimizes the deviation in a temporal section between the four- to fivefold time constants ($\tau$) and the metrological end of the settling phase at approximately 3/5 of the measuring period ($T_m$).

3. The method according to claim 1 or 2,
   **characterized in that**
   the approximation algorithm functions according to the least squares method.

4. The method according to any one of the claims 1 to 3,
   **characterized by**
   an application for determining the dielectric characteristics of an insulation in an ungrounded power supply system in conjunction with insulation monitoring.

5. A test apparatus for determining the elements of a dielectric equivalent circuit diagram for an insulation of an electric system,
   **characterized by**
   a signal processing device which is configured for executing the method according to the invention for determining the elements of a dielectric equivalent circuit diagram for an insulation of an electric system according to one of the claims 1 to 4.

6. An insulation monitoring device for identifying an insulation resistance of an ungrounded power supply system,
   **characterized by**
   a signal processing device which is configured for executing the method according to the invention for determining the elements of a dielectric equivalent circuit diagram for insulating an ungrounded power supply system according to one of the claims 1 to 4.

7. The insulation monitoring device according to claim 6,
   **characterized by**
   a variable measurement resistance ($R_m$) and/or a variable coupling impedance for low-noise detection for a test voltage (uo(t)) having variable amplitude.

**Revendications**

1. Procédé pour déterminer des éléments d'un diagramme de circuit équivalent diélectrique pour un isolement d'un système électrique, le diagramme de circuit équivalent étant un couplage en parallèle fait d'une résistance de défaut (Rf), d'une capacitance de fuite (Ce) et d'un élément d'absorption qui est fait d'un couplage en série d'une résistance

d'absorption ($R_a$) et d'une capacitance d'absorption ($C_a$), le procédé comprenant les étapes suivantes :

appliquer un saut de tension au système électrique comme tension de test (uo (t)) d'une source de tension ayant une résistance de mesure ($R_m$) connue en série à la source de tension ;

mesurer une tension chutant à la résistance de mesure ($R_m$) comme réponse de saut (ua(t)) du système électrique ;

**caractérisé par**

enregistrer la réponse de saut (ua(t)) pendant une période de mesure ($T_m$) dont duration correspond environ à une double phase de stabilisation de la réponse de saut (ua(t)) ;

compter la résistance de défaut (Rf) à partir de la progression de la réponse de saut (ua(t)) en état établi ;

déterminer les constantes de temps ($\tau$) à partir de la progression de la réponse de saut (ua(t)) dans la phase de stabilisation ;

compter une valeur initiale ($C_{e0}$) de la capacitance de fuite (Ce) à partir de constantes de temps ($\tau$), de la résistance de défaut (Rf) et de la résistance de mesure ($R_m$) ;

formant une fonction de transfert (G(s)) du système électrique, qui a été modelé par le diagramme de circuit équivalent en utilisant les éléments ($R_f$, $C_e$, $R_a$, $C_a$) du diagramme de circuit équivalent et la résistance de mesure ($R_m$), comme un rapport entre un signal de sortie (U'a(s)) à la résistance de mesure ($R_m$) et un signal de test (Uo(s)) de la source de tension comme signal d'entrée ;

compter le signal de sortie (U'a(s)) à partir de la fonction de transfert (G(s)) en utilisant une fonction de saut comme signal de test (Uo(s)) pendant que la résistance de défaut (Rf) comptée, la valeur initiale ($C_{e0}$) comptée de la capacitance de fuite ($C_e$) et la résistance de mesure ($R_m$) connue sont incorporées,

la résistance d'absorption ($R_a$), la capacitance d'absorption ($C_a$) et la capacitance de fuite ($C_e$) étant chacune déterminées itérativement par des valeurs approximatives ($R'_a$, $C'_a$, $C'_e$) au moyen d'un algorithme d'approximation de telle manière que la déviation entre le signal de sortie (u'a(t)) compté transformé pendant l'intervalle de temps et la fonction de saut (ua(t)) mesurée enregistrée est minimisée.

2. Procédé selon la revendication 1,
   **caractérisé en ce que**
   l'algorithme d'approximation minimise la déviation dans une période entre les quadruples à quintuples constantes de temps ($\tau$) et le fin métrologique de la phase de stabilisation à environ 3/5 de la période de mesure ($T_m$).

3. Procédé selon la revendication 1 ou 2,
   **caractérisé en ce que**
   l'algorithme d'approximation fonctionne selon la méthode des moindres carrés.

4. Procédé selon l'une quelconque des revendications 1 à 3,
   **caractérisé par**
   une application pour déterminer des caractéristiques diélectriques d'un isolement dans un système d'alimentation en courant non mis à la terre ensemble avec un surveillance d'isolement.

5. Appareil de test pour déterminer des éléments d'un diagramme de circuit équivalent diélectrique pour un isolement d'un système électrique,
   **caractérisé par**
   un dispositif de traitement de la signalisation qui est conçu pour exécuter le procédé selon l'invention pour déterminer les éléments d'un diagramme de circuit équivalent diélectrique pour un isolement d'un système électrique selon l'une des revendications 1 à 4.

6. Contrôleur permanent d'isolement pour identifier une résistance d'isolement d'un système d'alimentation en courant non mis à la terre,
   **caractérisé par**
   un dispositif de traitement de la signalisation qui est conçu pour exécuter le procédé selon l'invention pour déterminer les éléments d'un diagramme de circuit équivalent diélectrique pour un isolement d'un système d'alimentation en courant non mis à la terre selon l'une des revendications 1 à 4.

7. Contrôleur permanent d'isolement selon la revendication 6,
   **caractérisé par**
   une résistance de mesure ($R_m$) variable et/ou une impédance de couplage variable pour une détection sans bruit de fond pour une tension de test (uo(t)) ayant une amplitude variable.

**Fig. 1**

EP 3 696 557 B1

Fig. 2

**Fig. 3**

**Fig. 4**

EP 3 696 557 B1

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Return Voltage Measurements - a good tool for the diagnosis of paper-oil insulations. **RAINER PATSCH et al.** POWER TECH, 2005 IEEE RUSSIA. IEEE, 27. Juni 2005, 1-7